# EUROPÄISCHE PATENTSCHRIFT

(11) **EP 2 539 115 B1**
(45) Veröffentlichungstag und Bekanntmachung des Hinweises auf die Patenterteilung: **11.06.2014**
(21) Anmeldenummer: 11767379.8
(22) Anmeldetag: 30.09.2011
(51) Int. Cl.: B25J 9/10

(54) **MANIPULATIONSVORRICHTUNG**
MANIPULATION DEVICE
DISPOSITIF DE MANIPULATION

(30) Priorität: 01.10.2010 DE 102010047308
(43) Veröffentlichungstag der Anmeldung: 02.01.2013
(73) Patentinhaber: Weiss GmbH, 74722 Buchen (Odw.) (DE)
(72) Erfinder: WEISS, Uwe, 74722 Buchen (DE); PINXT, Joseph Aleida Mathieu Maria, NL-6471 CG Kerkrade (NL); SARBACH, Thomas, CH-3924 St. Niklaus (CH); HESS, Thomas, 74838 Limbach (DE)
(74) Vertreter: Manitz, Finsterwald & Partner GbR
(86) Internationale Anmeldenummer: PCT/EP2011/004909
(87) Internationale Veröffentlichungsnummer: WO 2012/041520

(56) Entgegenhaltungen:
- DE-A1- 10 206 414
- DE-A1- 19 806 085
- DE-A1-102004 058 437
- NL-C2- 1 019 443

## Beschreibung

Die vorliegende Erfindung betrifft eine Manipulationsvorrichtung zur Handhabung und/oder Bearbeitung eines Werkstücks.

Manipulationsvorrichtungen sind programmierbare Maschinen zur Handhabung, Montage und/oder Bearbeitung von Werkstücken. Sie gelangen in der Regel im industriellen Umfeld zum Einsatz. Durch eine geeignete Programmierung sind derartige Einrichtungen in der Lage, bestimmte Arbeitsabläufe zuverlässig autonom durchzuführen. An Manipulationsvorrichtungen werden hohe Anforderungen in Bezug auf die Zuverlässigkeit und die exakte Reproduzierbarkeit der programmierten Arbeitsabläufe gestellt. Zudem sollen derartige Vorrichtungen kompakt und robust sein. Der wirtschaftliche Erfolg solcher auch als Industrieroboter bezeichneter Vorrichtungen hängt zudem wesentlich davon ab, dass die Arbeitsabläufe schnell durchgeführt werden können, d.h. die von der Manipulationsvorrichtung erzeugten Bewegungen sollen eine hohe Dynamik aufweisen.

Es ist eine Aufgabe der vorliegenden Erfindung eine Manipulationsvorrichtung der vorstehend genannten Art zu schaffen, die die beschriebenen Anforderungen erfüllt und die gleichzeitig auch kostengünstig in der Herstellung und der Wartung ist.

Eine Manipulationsvorrichtung mit den Merkmalen des Oberbegriffs des Anspruchs 1 ist aus der DE 10 2004 058 437 A1 bekannt.

Diese Aufgabe wird durch eine Manipulationsvonichtung mit den Merkmalen des Anspruchs 1 gelöst.

Erfindungsgemäß umfasst die Manipulationsvorrichtung zur Handhabung und/oder Bearbeitung eines Werkstücks eine erste Bewegungseinheit zur Erzeugung einer linearen Bewegung eines ersten Bauteils und eine zweite Bewegungseinheit zur Erzeugung einer linearen Bewegung eines zweiten Bauteils. Die Bewegungseinheiten sind derart relativ zueinander angeordnet, dass die von den Bewegungseinheiten erzeugbaren Bewegungen parallel zueinander ausgerichtet sind. Das erste und das zweite Bauteil sind jeweils über eine erste bzw. zweite gelenkige Verbindung mit einem Befestigungselement verbunden, das zur Aufnahme des Werkstücks und/oder eines Werkzeugs geeignet ist. Die erste gelenkige Verbindung umfasst einen ersten Führungsarm, der mittels eines Drehgelenks mit dem ersten Bauteil gekoppelt ist, und die zweite gelenkige Verbindung umfasst einen zweiten Führungsarm, der mittels eines Drehgelenks mit dem zweiten Bauteil gekoppelt ist. Der erste Führungsarm und der zweite Führungsarm sind durch zumindest ein Drehgelenk relativ zueinander verschwenkbar direkt oder indirekt miteinander gekoppelt.

Mit anderen Worten weist die Manipulationsvorrichtung zwei jeweils entlang einer Geraden verfahrbare Bauteile auf, um Bewegungen des Befestigungselements zu erzeugen. Um dabei nicht nur eine eindimensionale Translationsbewegungen zu erzeugen, sondern auch Bewegungen in einer Ebene oder Schwenkbewegungen zu ermöglichen, ist das Befestigungselement über entsprechende gelenkige Verbindungen mit dem ersten und dem zweiten Bauteil verbunden. Durch eine individuelle Ansteuerung der Bewegungseinheiten, die parallel versetzt zueinander angeordnete Bewegungen des jeweiligen Bauteils erzeugen, kann aufgrund der durch die gelenkigen Verbindungen bereitgestellten Kopplung des Befestigungselements mit den beiden Bauteilen eine Positionsänderung des Befestigungselements bewirkt werden. Beispielsweise führt eine gleichsinnige und synchrone Aktivierung der beiden Bewegungseinheiten zu einer reinen Translationsbewegung des Befestigungselements. Werden die Bewegungseinheiten dahingegen so aktiviert, dass gegensinnige und/oder im Bewegungsbetrag unterschiedliche Bewegungen und/oder unterschiedlich schnelle Bewegungen der entsprechenden Bauteile erzeugt werden, kann die resultierende Bewegung des Befestigungselements beispielsweise eine Schwenkkomponente und/oder eine seitliche Bewegung aufweisen. Die vorstehend beschriebene Manipulationsvorrichtung ist somit in der Lage, mit Hilfe von zwei parallel bewegbaren Bauteilen zweidimensionale Bewegungen des Befestigungselements zu erzeugen. Das heißt, das Befestigungselement, das beispielsweise mit einem Greifer zur Aufnahme eines Werkstücks oder einem Werkzeug zur Bearbeitung eines Werkstücks versehen ist, kann in einer Ebene bewegt werden, ohne dass zwei senkrecht zueinander angeordnete lineare Bewegungsachsen oder Schwenkantriebe erforderlich sind.

Durch die parallele Anordnung der Bewegungsrichtungen der beiden Bauteile wird eine robuste Konstruktion geschaffen, die die Manipulation von - in Bezug auf die Auslegung der Bewegungseinheiten gesehen - vergleichsweise großer Massen ermöglicht. Aufgrund der parallelen Ausrichtung der Bauteile unterstützen sich diese gegenseitig bei der Aufnahme der zu bewegenden Massen. Im Umkehrschluss bedeutet dies, dass die Manipulationsvorrichtung, die für eine bestimmte Maximallast ausgelegt ist, weniger massiv ausgeführt sein muss als ein herkömmlicher Industrieroboter. Insbesondere die linear verfahrbaren Bauteile der Bewegungseinheit können daher leichter konstruiert sein als entsprechende Komponenten bekannter Vorrichtungen, was sich positiv auf die Bewegungsdynamik auswirkt. Zudem kann die Manipulationsvorrichtung insgesamt "schlanker" und kompakter gestaltet werden.

Bevorzugt werden gleichartige Bewegungseinheiten verwendet, die einen symmetrischen Aufbau der Manipulationsvorrichtung ermöglichen. Durch die Verwendung gleicher Bewegungseinheiten entstehen ferner Kostenvorteile bei der Herstellung und der Wartung der Manipulationsvorrichtung.

Eine Ausgestaltung der gelenkigen Verbindungen mit Führungsarmen ist konstruktiv einfach und ermöglicht eine zuverlässige Führung des Befestigungselements durch die Bewegung der beiden Bauteile. Durch das Drehgelenk zwischen dem jeweiligen Bauteil und dem entsprechenden Führungsarm können Geometrieänderungen zwischen den beiden genannten Komponenten aufgenommen werden. Grundsätzlich können die Führungsarme mehrere Komponenten umfassen, die - aktiv und/oder passiv - zueinander verschwenkbar sind. In der Regel ist es jedoch vorgesehen, dass die Führungsarme starre Bauelemente sind.

Ferner sind der erste Führungsarm und der zweite Führungsarm miteinander gekoppelt. Eine Bewegung der Bauteile wird so über die Führungsarme in eine Bewegung des Befestigungselements umgewandelt. Die resultierende Bewegung des Befestigungselements wird daher durch die geometrische Anordnung der beiden Bauteile und die Ausgestaltung sowie das Zusammenspiel der Führungsarme festgelegt. Die Kopplung zwischen den beiden Führungsarmen umfasst zumindest ein Drehgelenk, das die erste und die zweite gelenkige Verbindung relativ zueinander verschwenkbar direkt oder indirekt miteinander koppelt.

Der erste Führungsarm und der zweite Führungsarm sind durch separate Drehgelenke mit dem Befestigungselement gekoppelt. D.h. die beiden Führungsarme stehen nicht in direktem Kontakt miteinander, sodass eine indirekte Kopplung der Führungsarme über das Befestigungselement realisiert ist.

Die erste gelenkige Verbindung umfasst einen dritten Führungsarm, der mittels eines Drehgelenks mit dem ersten Bauteil gekoppelt ist, und die zweite gelenkige Verbindung umfasst einen vierten Führungsarm, der mittels eines Drehgelenks mit dem zweiten Bauteil gekoppelt ist. Durch die zusätzlichen Führungsarme wird zum einen eine stabile Ausgestaltung der Kopplung zwischen dem Befestigungselement und dem ersten und dem zweiten Bauteil bereitgestellt. Ferner kann durch die Ausgestaltung des dritten und des vierten Führungsarms Einfluss auf die Bewegung des Befestigungselements in Reaktion auf ein Verfahren des ersten und/oder des zweiten Bauteils genommen werden.

Das Befestigungselement umfasst eine Basisplatte und eine Arbeitsplatte, wobei der erste Führungsarm und der zweite Führungsarm durch separate Drehgelenke mit der Basisplatte gekoppelt sind und der dritte Führungsarm und der vierte Führungsarm durch separate Drehgelenke mit der Arbeitsplatte gekoppelt sind. Beispielsweise liegen die befestigungselementseitigen Drehgelenke des ersten und des dritten Führungsarms auf einer Linie, die parallel zu den Bewegungsrichtungen der Bauteile angeordnet ist. Analoges kann für die befestigungselementseitigen Drehgelenke des zweiten und des vierten Führungsarms gelten. Es ist auch möglich, die bauteilseitigen Drehgelenke der Führungsarme entsprechend zu positionieren.

Die Basisplatte und die Arbeitsplatte können fest miteinander verbunden sein, um ein starres Befestigungselement zu bilden, an dem die Führungsarme verschwenkbar befestigt sind.

In vielen Fällen ist es vorteilhaft, wenn der erste Führungsarm und der dritte Führungsarm gleich lang sind und wenn der zweite Führungsarm und der vierte Führungsarm gleich lang sind. Es kann auch vorgesehen sein, dass alle Führungsarme gleich lang sind. Die Führungsarme bilden ein Parallelogramm, das durch die Längen der Führungsarme und die Abstände der bauteilseitigen Drehgelenke definiert ist. Eine relative Bewegung der Bauteile führt zu einer Verzerrung des Parallelogramms, wobei allerdings eine Ausrichtung des Befestigungselements unverändert bleibt. Lediglich die Position des Befestigungselements wird innerhalb einer durch die Bauteile aufgespannten Ebene verändert.

Um die Flexibilität der Manipulationsvorrichtung zu erhöhen, ist das Befestigungselement - aktiv oder passiv - verdrehbar relativ zu den gelenkigen Verbindungen bzw. den Führungsarmen angeordnet. Bevorzugt ist das Befestigungselement jeweils - direkt oder indirekt - drehbar mit den Führungsarmen gekoppelt, insbesondere im Bereich des die Führungsarme verbindenden Drehgelenks oder durch das Drehgelenk selbst.

Dem Befestigungselement kann eine Rotationseinrichtung zugeordnet sein (nicht Teil der Erfindung), mit der eine Ausrichtung des Befestigungselements relativ zu zumindest einem der Führungsarme veränderbar ist. Beispielsweise kann ein von einer Steuereinrichtung steuerbarer Schwenkantrieb vorgesehen sein, der bei Bedarf einer Ausrichtung des Befestigungselements und damit des daran angeordneten Werkstücks und/oder Werkzeugs ändert. Es ist auch möglich, dem Befestigungselement eine Rotationseinrichtung zuzuordnen, die derart ausgestaltet ist, dass eine Ausrichtung des Befestigungselements relativ zu den Bewegungsrichtungen der Bewegungseinheiten - insbesondere automatisch - unabhängig von einer relativen Stellung der Bauteile beibehaltbar ist. Dadurch kann verhindert werden, dass sich das Befestigungselement bei einer relativen Bewegung der beiden Bauteile verdreht. Das heißt, das an dem Befestigungselement angeordnete Werkstück bzw. Werkzeug führt dann bei unterschiedlichen Bewegungen der beiden Bauteile zwar eine Bewegung im Raum aber keine Rotation um sich selbst aus, sondern behält seine Ausrichtung in Bezug auf die Bewegungsrichtungen der Bewegungseinheiten oder die Umgebung bei.

Zu diesem Zweck kann die Rotationseinrichtung eine Übertragungseinrichtung umfassen, mit der eine Veränderung einer Winkelstellung des ersten Führungsarms relativ zu dem ersten Bauteil oder des zweiten Führungsarms relativ zu dem zweiten Bauteil auf das Befestigungselement übertragbar ist, wobei die Übertragungseinrichtung insbesondere ein verzahntes Band umfasst, das mit einem drehfest mit dem ersten oder mit dem zweiten Bauteil verbundenen oder fixierbaren Zahnrad und einem drehfest mit der Befestigungseinrichtung verbundenen oder fixierbaren Zahnrad zusammenwirkt. Das Band kompensiert somit eine Verschwenkung des entsprechenden Führungsarms, die bei einer festen Winkelbeziehung zwischen dem Befestigungselement und dem Führungsarm zu einer Verdrehung des Befestigungselements relativ zu seiner Umgebung führen würde. Insbesondere ist jedem Führungsarm eine eigene Übertragungseinrichtung zugeordnet, um die dynamische Steifigkeit der Gesamtanordnung zu erhöhen.

Um Situationen aufzulösen, in denen die Führungsarme 180° zueinander ausgerichtet sind (Superpositionsstellung), kann eine Überlagerungseinheit vorgesehen sein (nicht Teil der Erfindung), durch die bei Bewegung zumindest eines der Bauteile auf die dadurch erzeugte Konfiguration der Führungsarme Einfluss genommen werden kann. Durch eine Bewegung der Bewegungseinheiten alleine ist in derartigen Situationen nicht immer gewährleistet, dass die Führungsarme in eine gewünschte Konfiguration, d.h. in eine bestimmte relative Stellung, gebracht werden. Die Überlagerungseinheit gestattet es, direkt oder indirekt auf die Führungsarme einzuwirken, um sicherzustellen, dass eine gewünschte Bewegung der Führungsarme - und damit des Befestigungselements - bewirkt wird.

Beispielweise ist die Überlagerungseinheit derart ausgestaltet, dass selektiv eine Relativbewegung zwischen zumindest einem der Bauteile der Bewegungseinheiten - insbesondere beiden Bauteilen - und dem Befestigungselement erzeugbar ist. Die Relativbewegung ist insbesondere eine relative Verdrehung des Befestigungselements. Die Überlagerungseinheit kann beispielsweise ein verzahntes Band umfassen, das mit einem zu einer Drehbewegung antreibbaren, an dem ersten oder dem zweiten Bauteil angeordneten Zahnrad und mit einem dem Befestigungselement zugeordneten Zahnrad zusammenwirkt. Insbesondere ist beiden Bauteilen jeweils ein verzahntes Band zugeordnet.

Durch eine Verdrehung der Zahnräder wird auf das Befestigungselement eine Kraft ausgeübt, die es zum Beispiel zur Basis hin oder davon weg drückt. Die Superpositionsstellung kann so in steuerbarer Weise aufgelöst werden. In der Regel sind bereits geringe Verdrehungsbeträge ausreichend, um die notwendige Kraft aufzubringen. Bei symmetrischer Anordnung der Überlagerungseinheit, d.h. wenn das Befestigungselement über jeweils ein Band mit beiden Bauteilen in direkter Verbindung steht, kann die gewünschte, die Superpositionsstellung auflösende Überlagerungskraft auf effiziente Wiese durch gegensinnige Drehung der den Bauteilen zugeordneten Zahnräder bewirkt werden.

Es ist ohne weiteres ersichtlich, dass die vorstehend erläuterte Ausbildung der Überlagerungseinheit auch die kompensierende Funktion der Rotationseinrichtung übernehmen kann. Zu diesem Zweck müssen lediglich die an den Bauteilen angeordneten Zahnräder drehfest fixierbar sein. Dies wird beispielsweise durch eine geeignete Ausgestaltung der die Zahnräder antreibenden Einheiten ermöglicht. Zusätzlich oder alternativ können geeignete Arretierungsmittel vorgesehen sein. Die Überlagerungseinheit und die Rotationseinrichtung können auch getrennte Baugruppen sein.

Gemäß einer weiteren Ausgestaltung der Überlagerungseinheit ist diese derart ausgestaltet, dass selektiv eine Kopplung zwischen zumindest einem der Führungsarme und dem Befestigungselement herstellbar ist. Bevorzugt ist diese Kopplung eine magnetische Kopplung. Beispielsweise umfasst die Überlagerungseinheit eine Spule, durch die bei Strombeaufschlagung ein Magnetfeld erzeugbar ist, das mit einem Magneten zusammenwirkt. Bevorzugt ist die Spule an dem Befestigungselement angeordnet, während der Magnet einem der Führungsarme zugeordnet ist.

Es kann vorgesehen sein, dass die Spule und der Magnet derart an dem Befestigungselement bzw. an einem der Führungsarme angeordnet sind, dass sie bei einer geradlinigen Anordnung der Führungsarme einen minimalen Abstand einnehmen. Mit anderen Worten sollen die Spule und der Magnet derart positioniert sein, dass sie sich in der Superpositionsstellung möglichst nah beieinander befinden, um eine effiziente Kopplung der genannten Komponenten zu erzielen. Da die Führungsarme und das Befestigungselement bei den möglichen Superpositionsstellungen relativ zueinander unterschiedlich angeordnet sind, kann für jede Superpositionsstellung zumindest eine Magnet-Spule-Paarung vorgesehen sein. Es versteht sich, dass bei einer Verwendung anderer Kopplungsmechanismen diese ebenfalls derart ausgestaltet sein können, dass alle Superpositionsstellungen beeinflussbar sind.

Zur Erhöhung der Stabilität der Manipulationsvorrichtung kann ein Kopplungselement vorgesehen sein, das zusätzlich zu einer Kopplung über die gelenkige Verbindungen und das Befestigungselement eine weitere Kopplung zwischen dem ersten Bauteil und dem zweiten Bauteil herstellt. Mit anderen Worten wird ein zusätzlicher Kopplungspfad bereitgestellt, der das erste und das zweite Bauteil verbindet und der nicht das Befestigungselement und/oder die gelenkigen Verbindungen umfasst. Durch das Kopplungselement werden die beiden Bauteile zur gegenseitigen Stabilisierung direkt miteinander gekoppelt. Bei einer geeigneten Ausgestaltung des Kopplungselements wird beispielsweise verhindert, dass die beiden Bauteile durch quer zur Bewegungsrichtung wirkende Kräfte auseinander- oder zusammengedrückt werden, was insbesondere problematisch ist, wenn die beiden Bauteile in einem "ausgefahrenem" Zustand sind, d.h. wenn sich das Befestigungselement vergleichsweise weit weg von den Bewegungseinheiten befindet.

Gemäß einer Ausführungsform ist das Kopplungselement an dem ersten Bauteil und an dem zweiten Bauteil verfahrbar angeordnet. Insbesondere ist das Kopplungselement parallel zu den Bewegungsrichtungen und/oder Längserstreckungen der Bauteile verfahrbar. Das Kopplungselement kann somit entlang der Bauteile verschoben werden, um beispielsweise sicherzustellen, dass diese einen im Wesentlichen konstanten Abstand einhalten.

Das Kopplungselement kann ein Zahnrad umfassen, das mit einer an dem ersten Bauteil angeordneten Verzahnung und mit einer an dem zweiten Bauteil angeordneten Verzahnung kämmt. Die Verzahnungen sind insbesondere im Bereich der bauteilseitigen Drehgelenke angeordnet. Das Zusammenspiel des Zahnrads mit den Verzahnungen führt bei geeigneter Auslegung der Komponenten dazu, dass sich das Kopplungselement stets in einem gewünschten Bereich - d.h. im Bereich der Verzahnungen - befindet, wo die größten Querbelastungen auf die Bauteile wirken. Mit anderen Worten wird durch den beschriebenen Mechanismus auf einfache Weise sichergestellt, dass sich das Kopplungselement stets in der richtigen Position befindet, um effizient zur Stabilität der Manipulationsvorrichtung beizutragen. Wesentlich ist letztlich, dass das Kopplungselement nicht während des Betriebs der Manipulationsvorrichtung aus dem Bereich "wandert", in dem die größten Belastungen auftreten und in dem das Kopplungselement folglich auch die größten Vorteile erzielt. Gleichzeitig soll sichergestellt werden, dass das Kopplungselement keinen nachteiligen Einfluss auf die Dynamik der Manipulationsvorrichtung hat.

Gemäß einer vorteilhaften Ausführungsform sind die erste und die zweite Bewegungseinheit in einer Ebene angeordnet, die in Gebrauchslage der Manipulationsvorrichtung im Wesentlichen horizontal angeordnet ist. Es versteht sich aber, dass grundsätzlich beliebige Orientierungen der Ebene vorstellbar sind, wie etwa eine vertikale oder eine schräge Anordnung der Ebene im Raum.

Die Bewegungseinheiten können an einer gemeinsamen Basis verfahrbar angeordnet sein, wobei sich eine Verfahreinrichtung der Bewegungseinheiten - bezogen auf eine Gebrauchslage der Manipulationsvorrichtung - insbesondere senkrecht zu den von den Bewegungseinheiten erzeugbaren linearen Bewegungen des ersten und des zweiten Bauteils erstreckt. Eine derartige Ausgestaltung der Manipulationsvorrichtung ermöglicht eine dreiachsige Manipulation von Werkstücken und erhöht daher ihre Einsatzmöglichkeiten. Es ist auch möglich, die Bewegungseinheiten an separaten Basiseinheiten verfahrbar anzuordnen. Die Bewegungseinheiten können mechanisch miteinander gekoppelt sein, um ein synchrones Verfahren zu garantieren. Ist jeder der Bewegungseinheiten ein eigener Mechanismus zum vertikalen Verfahren zugeordnet, kann eine Synchronisierung zusätzlich oder alternativ durch eine Steuereinheit bewirkt werden.

Bevorzugt sind die Bewegungseinheiten Linearmotoren. Es sind daher keine Wandlereinrichtungen notwendig, die die von den herkömmlicherweise verwendeten Motoren bereitgestellten Drehbewegungen in die linearen Bewegungen des ersten und des zweiten Bauteils umwandeln.

Die Summe der Längen der ersten und der zweiten gelenkigen Verbindung, insbesondere die Summe der Längen der beiden Führungsarme, kann größer sein als ein Abstand zwischen den Bewegungsrichtungen der Bewegungseinheiten. Mit anderen Worten sind die gelenkigen Verbindungen in ihrer maximalen Längserstreckung zusammengenommen länger als ein Abstand zwischen den beiden Bewegungsrichtungen der Bewegungseinheit. Zwar ist es nicht zwingend notwendig, dass die maximalen Längen der beiden gelenkigen Verbindungen gleich lang sind, in vielen Fällen erweist sich dies allerdings als vorteilhaft.

Ferner wird ein Verfahren zum Betrieb einer Manipulationsvorrichtung zur Handhabung und/oder Bearbeitung eines Werkstücks angegeben, die eine Bewegungseinheit zur Erzeugung einer linearen Bewegung eines ersten Bauteils und eine zweite Bewegungseinheit zur Erzeugung einer linearen Bewegung eines zweiten Bauteils umfasst. Das erste Bauteil ist über einen ersten Führungsarm und das zweite Bauteil über einen zweiten Führungsarm mit einem Befestigungselement verbunden, das zur Aufnahme des Werkstücks und/oder eines Werkzeugs geeignet ist. Die beiden Führungsarme sind über zumindest ein Drehgelenk schwenkbar direkt oder indirekt miteinander gekoppelt.

Das Verfahren sieht vor, dass das erste Bauteil und das zweite Bauteil synchron und um einen gleichen Betrag parallel in eine Richtung bewegt werden, um eine lineare Translationsbewegung des Befestigungselements zu erzeugen. Um eine eine Schwenkbewegung umfassende Bewegung des Befestigungselements zu erzeugen, die auch eine zusätzliche lineare Translationsbewegungskomponente umfassen kann, werden das erste Bauteil und das zweite Bauteil in entgegengesetzte Richtungen und/oder um einen unterschiedlichen Betrag bewegt.

Mit anderen Worten wird eine reine lineare Translationsbewegung durch eine synchrone und gleichsinnige Bewegung der Bauteile erzeugt, während unterschiedliche - gegensinnige und/oder ungleich große und/oder ungleich schnelle - Bewegungen der Bauteile eine Bewegung des Befestigungselements erzeugt, die eine Schwenkkomponente umfasst und/oder die einen seitlichen Versatz des Befestigungselement bewirkt. Ein Vorteil dieses Verfahrens besteht somit unter anderem darin, dass das Befestigungselement durch die zwei parallel wirkenden Bewegungseinheiten in einer Ebene bewegt werden kann. Dies ermöglicht den Einsatz konstruktiv einfach aufgebauter und kostengünstig herzustellender und zu wartender Manipulationsvorrichtungen.

Weitere Ausführungsformen der Erfindung sind in der Beschreibung, den Unteransprüchen und den Zeichnungen angegeben.

Nachfolgend wird die Erfindung rein beispielhaft anhand vorteilhafter Ausführungsformen unter Bezugnahme auf die beigefügten Fig. 7 bis 12 beschrieben. Es zeigen:
- Fig. 1: ein Beispiel einer Manipulationsvorrichtung in einer Perspektivansicht,
- Fig. 2 und 3: das in Fig. 1 dargestellte Beispiel in einer Seitenansicht bzw. Draufsicht,
- Fig. 4: eine Prinzipskizze einer Variante der Übertragungseinrichtung,
- Fig. 5: eine schematische Darstellung einer Superpositionsstellung der Führungsarme,
- Fig. 6a und 6b: Prinzipskizzen einer Überlagerungseinheit in verschieden Superpositionsstellungen,
- Fig. 7 bis 11: verschiedene Ansichten einer Ausführungsform der erfindungsgemäßen Manipulationsvorrichtung und
- Fig. 12 bis 14: Schnittansichten der gelenkigen Verbindungen der Ausführungsform der Fig. 7 bis 11.

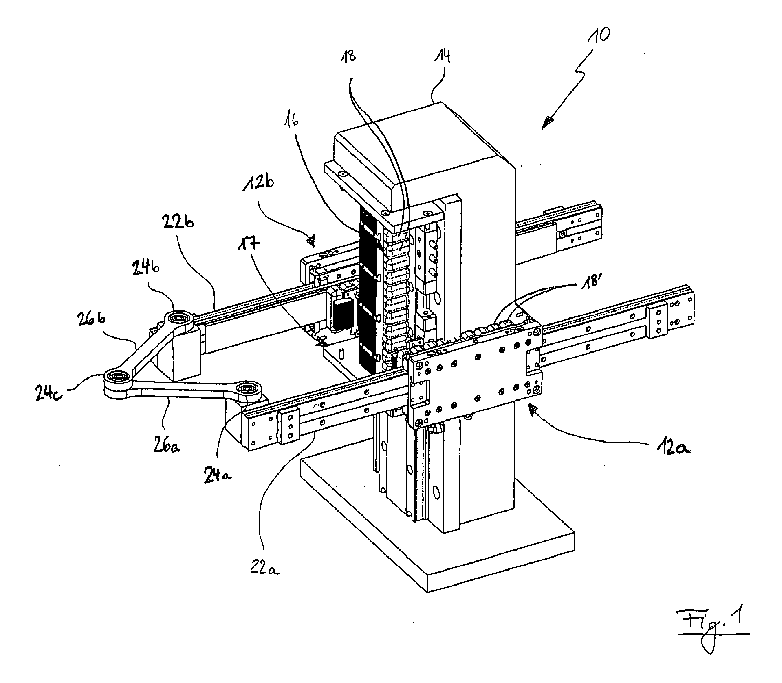

Fig. 1 zeigt eine Manipulationsvorrichtung 10 mit zwei Linearmotoren 12a, 12b, die symmetrisch seitlich an einer Basis 14 angeordnet sind. Die Linearmotoren 12a, 12b sind an der Basis 14 in vertikaler Richtung mittels eines Linearmotors 16 verfahrbar angeordnet. Der Linearmotor 16 umfasst an einem die Linearmotoren 12a, 12b tragenden und miteinander koppelnden Schlitten 17 angeordnete Spulen 18 und an der Basis angebrachten Permanentmagneten (nicht zu sehen). Die Spulen 18 werden durch eine nicht gezeigte Steuereinrichtung selektiv bestromt, um durch ein Zusammenwirken mit den Permanentmagneten 20 die Linearmotoren 12a, 12b vertikal zu verfahren.

Die Linearmotoren 12a, 12b weisen jeweils einen Läufer 22a bzw. 22b auf, die jeweils durch eine Spulen-Permanentmagnetanordnung vergleichbar mit der des Linearmotors 16 zu linearen Bewegungen in einer horizontalen Ebene antreibbar sind. Die Spulen 18' der Linearmotoren 12a, 12b sind dem Schlitten 17 zugeordnet, während die Permanentmagneten an den Läufern 22a, 22b angebracht sind.

Die Läufer 22a, 22b der Linearmotoren 12a, 12b sind an ihrem in Fig. 1 linken Ende über Drehgelenke 24a bzw. 24b mit Führungsarmen 26a bzw. 26b verbunden. Die Führungsarme 26a, 26b sind wiederum an ihrem dem jeweiligen Läufer 22a bzw. 22b abgewandten Ende über ein Drehgelenk 24c miteinander gekoppelt. An dem Drehgelenk 24c oder an einem der Führungsarme 26a, 26b kann ein Befestigungselement (nicht gezeigt) angeordnet sein, das zur Aufnahme eines zu bewegenden Werkstücks und/oder eines Werkzeugs zur Bearbeitung eines Werkstücks vorgesehen sein.

Um eine Bewegung des Befestigungselements in einer durch die Läufer 22a, 22b aufgespannten Ebene zu bewirken, werden die Linearmotoren 12a, 12b von einer nicht gezeigten Steuereinrichtung angesteuert. Werden beide Läufer 22a, 22b synchron in die gleiche Richtung um den gleichen Betrag verfahren, wird eine Bewegung des Befestigungselements erzeugt, die parallel zu den Längsachsen der Läufer 22a, 22b verläuft. Bei einer unterschiedlichen Ansteuerung der Linearmotoren 12a, 12b wird eine Bewegung des Befestigungselements erzeugt, die - gegebenenfalls neben einer reinen linearen Translationsbewegungskomponente - eine Schwenkbewegungskomponente umfasst. Wird beispielsweise der Linearmotor 22a nicht bewegt, während der Läufer 22b des Linearmotors 12b verfahren wird, vollführt das Befestigungselement eine Kreisbewegung um das Drehgelenk 24a, wobei der Radius der Kreisbewegung der Länge des Führungsarms 26a entspricht. Bewegen sich im Gegensatz dazu beide Läufer 22a, 22b in die gleiche Richtung, aber um einen unterschiedlichen Betrag, so ergibt sich eine Bewegung, die die Summe einer Translationsbewegung und einer Kreisbewegung ist, wobei die genaue Bewegung von dem Betrag und der Geschwindigkeit der Bewegungen der beiden Läufer 22a, 22b abhängt. Durch eine gegensinnige Bewegung der Läufer 22a, 22b - d.h. im Falle einer Bewegung der Läufer 22a, 22b in entgegengesetzte Richtungen - wird ebenfalls eine derartige, kombinierte Bewegungsbahn des Befestigungselements erzeugt.

Anders als in Fig. 1 gezeigt, können die Führungsarme 26a, 26b auch unterschiedlich lang ausgeführt sein, um besonderen Anforderungen Rechnung zu tragen. Es versteht sich ferner, dass die Basis 14 bei Bedarf drehbar um eine vertikale oder horizontale Achse gelagert sein kann, um zusätzliche Freiheiten zur Erzeugung einer Bewegung des Befestigungselements bereitstellen zu können und den Wirkungsbereich der Manipulationsvorrichtung 10 vergrößern. Anstelle der Basis 14 können auch zwei Basiseinheiten vorgesehen sein, die separat voneinander jeweils einen der Linearmotoren 12a, 12b tragen.

Bei der Manipulationsvorrichtung 10 ergibt sich die vertikale Bewegbarkeit der Linearmotoren 12a, 12b durch die Länge des Linearmotors 16, während die in der horizontalen Ebene erreichbaren Punkte durch die Länge der Läufer 22a, 22b und die Ausgestaltung der Führungsarme 26a, 26b definiert ist. Abweichend von der in Fig. 1 dargestellten Beispiel einer Manipulationsvorrichtung 10 können sich die Führungsarme 26a, 26b ausgehend von den Drehgelenken 24a, 24b zur Basis 14 hin erstrecken, um ein nach innen gerichtetes V zu bilden. Es ist auch möglich, die Manipulationsvorrichtung 10 so auszugestalten, dass zwischen einer in Fig. 1 gezeigten Konfiguration der Führungsarme 26a, 26b, die ein nach außen gerichtetes V bilden, und einer Konfiguration mit nach innen gerichtetem V überführbar ist. Zu diesem Zweck ist es vorteilhaft, eine Einrichtung bereitzustellen, die bei einem Übergang zwischen den beiden Konfigurationen, in dem die Führungsarme 26a, 26b eine Gerade bilden auf der die Drehgelenke 24a, 24b, 24c liegen (Superpositionsstellung), sicher stellt, dass tatsächlich die gewünschte Konfiguration eingenommen wird und nicht ein "Zurückklappen" in die Ausgangskonfiguration erfolgt. Verschiedene Varianten einer derartigen Einrichtung werden nachfolgend noch näher beschrieben.

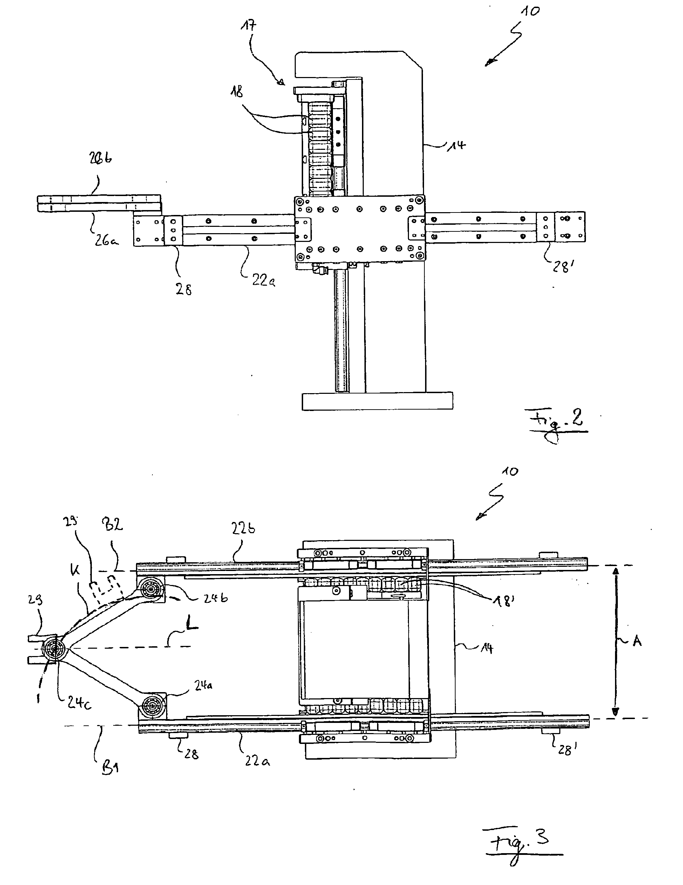

Fig. 2 zeigt die Manipulationsvorrichtung 10 in einer Seitenansicht, wodurch die Spulen 18 des Linearmotors 16 deutlich zu erkennen sind. Außerdem sind Anschläge 28, 28' an dem Läufer 22a zu sehen, die eine maximale Bewegung des Läufers 22a begrenzen.

Fig. 3 zeigt eine Draufsicht auf die Manipulationsvorrichtung 10, anhand derer nochmals die geometrischen Verhältnisse bei einer Bewegung der Läufer 22a, 22b deutlich werden. Es versteht sich, dass eine synchrone Bewegung der Läufer 22a, 22b entlang ihrer jeweiligen Bewegungsrichtung B1, B2, die um einen Abstand A parallel versetzt angeordnet sind, zu einer Bewegung des Drehgelenks 24c entlang einer Linie L führt. Wenn lediglich der Läufer 22b bewegt wird, bewegt sich das Drehgelenk 24c und damit das in diesem Bereich befestigte Befestigungselement - beispielsweise ein Greifer 29 - auf einer Kreisbahn K. Eine Bewegung beider Läufer 22a, 22b bewirkt eine Mischform der vorstehend beschriebenen Extrembeispiele.

Aus den vorstehenden Betrachtungen ist ersichtlich, dass der Greifer 29 bei einer Bewegung auf der Kreisbahn K oder bei einer der vorstehend beschriebenen Bewegungs-Mischform verschwenkt wird, wenn er starr an dem Drehgelenks 24c befestigt ist. In Fig. 3 wird diese Situation durch eine gestrichelte Darstellung des Greifers 29 versinnbildlicht. Das heißt, eine Ausrichtung des Greifers 29 in Bezug auf die Umgebung (beispielsweise die Basis 14) wurde verändert. Zwar kann dies in gewissen Fällen gewünscht sein, allerdings erweist es sich als vorteilhaft, wenn diese Rotation durch einen geeigneten Mechanismus kompensiert wird, so dass die Ausrichtung des Greifers 29 in Bezug auf die Basis 14 nicht verändert wird.

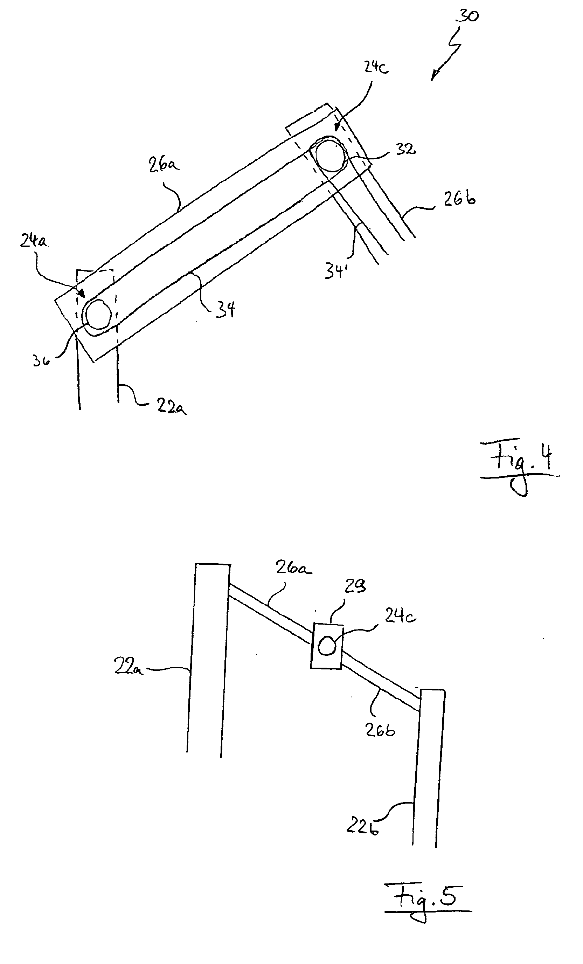

Fig. 4 zeigt einen Kompensationsmechanismus 30, der dies sicherstellt. Das Drehgelenk 24c (nicht im Detail gezeigt) ist dabei so ausgeführt, dass einerseits die beiden Führungsarme 26a, 26b relativ zueinander verschwenkbar miteinander gekoppelt sind, andererseits aber auch eine Verdrehung eines Befestigungselements (nicht im Detail gezeigt) relativ zu den beiden Führungsarmen 26a, 26b möglich ist. Dem Befestigungselement ist ein drehfest mit ihm verbundenes Zahnrad 32 zugeordnet, das über ein verzahntes Band 34 - vorzugsweise ein Stahlband - mit einem Zahnrad 36 gekoppelt ist, das drehfest an dem Läufer 22a und koaxial zu dem Drehgelenk 24a (nicht im Detail gezeigt) angeordnet ist. Wird durch eine Relativbewegung der beiden Läufer 22a, 22b eine Verschwenkung des Führungsarms 26a erzeugt, so führt dies zu einer Bewegung des Bands 34, die wiederum eine entsprechende Verdrehung des Zahnrads 32 und damit des mit ihm verbundenen Befestigungselements hervorruft. Da die beiden Zahnräder 32, 36 den gleichen Radius aufweisen, wird die Verschwenkung des Führungsarms 26a in gleichem Maße auf das Befestigungselement übertragen. Die Ausrichtung des Befestigungselements nach Verschwenkung des Führungsarms 26a entspricht daher der Ausrichtung vor Verschwenkung des Führungsarms 26a, obwohl eine Verschiebung des Befestigungselements in der Bildebene erfolgt ist.

Grundsätzlich ist es ausreichend, dass der Kompensationsmechanismus 30 die vorstehend beschriebenen Komponenten aufweist, um seine Funktion zu erfüllen. Allerdings ist es auch aus Stabilitätsgründen bevorzugt, dass - wie in Fig. 4 ansatzweise dargestellt - ein zweites Band 34' vorgesehen ist, das das Zahnrad 32 mit einem nicht gezeigten Zahnrad des Führungsarms 26b koppelt.

Dem Befestigungselement kann ein aktiv betreibbarer Schwenkmechanismus zugeordnet sein, der bei Bedarf eine Veränderung der Ausrichtung des Befestigungselements ermöglicht. Er kann zusätzlich zu dem Kompensationsmechanismus 30 vorgesehen sein, so dass stets eine automatische Kompensation der Verschwenkbewegung der Führungsarme 26a, 26b erfolgt und zusätzlich - beispielsweise bei der Aufnahme oder Bearbeitung eines Werkstücks - eine kontrollierte Drehung des Befestigungselements möglich ist. Der Schwenkmechanismus kann auch den Kompensationsmechanismus 30 ersetzen. Die vorstehend genannte Kompensation wird dann durch eine geeignete Ansteuerung des Schwenkmechanismus mit Hilfe einer Steuereinrichtung bereitgestellt.

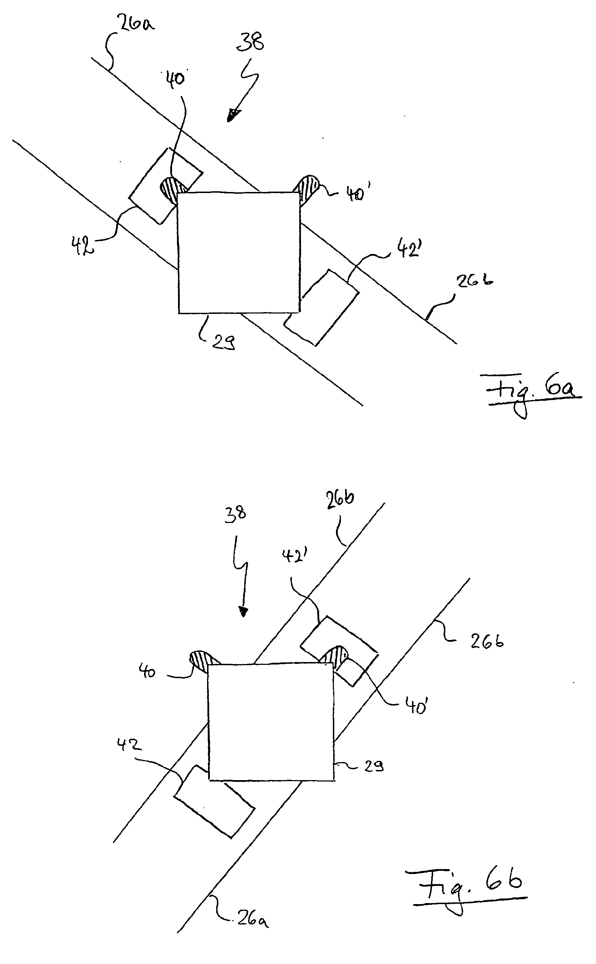

Fig. 5 zeigt eine Variante der vorstehend bereits erwähnten Superpositionsstellung, bei der die beiden Führungsarme 26a, 26b in einer Linie angeordnet sind, d.h. in einem Winkel von 180° zueinander angeordnet sind. Es versteht sich, dass eine ähnliche Superpositionsstellung vorliegt, wenn sich der Läufer 22a in einer Position befindet, die der des Läufers 22b in Fig. 5 entspricht und umgekehrt. Zum kontrollierten Auflösen dieser Stellung kann eine Überlagerungseinheit vorgesehen sein, die auf zumindest einen der Führungsarme 26a, 26b oder den Greifer 29 einwirkt, um eine Kraft zu erzeugen, durch die die Führungsarme 26a, 26b bei einer Bewegung der Läufer 22a, 22b in die gewünschte Konfiguration gezwungen werden. Ein Beispiel einer solchen Überlagerungseinheit ist in Fig. 6a und 6b gezeigt.

Fig. 6a zeigt eine Überlagerungseinheit 38. Diese umfasst zwei Spulen 40, 40', die an dem Greifer 29 angeordnet sind. In einer ersten Superpositionsstellung befindet sich die Spule 40 über einem Magneten 42, der an dem Führungsarm 26a angeordnet ist. Bei Bestromung der Spule 40 wird zwischen dieser und dem Magnet 42 eine Kopplung hergestellt, die letztlich eine gewisse Kopplung zwischen dem Greifer 29 und dem Führungsarm 26a bewirkt. Durch diese Kopplung kann Einfluss darauf genommen werden, welche Konfiguration die beiden Führungsarme 26a, 26b einnehmen, wenn sich zumindest einer der beiden Führungsarme 26a, 26b bewegt. Bewegt sich beispielsweise der mit dem Führungsarm 26b verbundene Läufer 22b nach oben, wird durch die vorstehend beschriebene Kopplung sichergestellt, dass eine V-förmige Konfiguration der Führungsarme 26a, 26b eingenommen wird. Mit anderen Worten dämpft oder verhindert die Kopplung des Führungsarms 26a mit dem Greifer 29 eine Relativbewegung zwischen diesen beiden Komponenten, während eine Verschwenkbarkeit zwischen dem Führungsarm 26b und dem Greifer 29 nicht beeinträchtigt ist.

Bereits eine vergleichsweise schwache Kopplung zwischen der Spule 40 und dem Magnet 42 reicht in der Regel aus, um die Verschwenkbarkeit zwischen dem entsprechenden Führungsarm 26a, 26b und dem Greifer 29 so zu beeinflussen, dass der gewünschte Effekt eintritt.

Wäre lediglich die Spule 40 vorgesehen, so könnte die in Fig. 6b gezeigte zweite mögliche Superpositionsstellung nicht selektiv aufgelöst werden, da keine Kopplung zwischen dem Greifer 29 und einem der Führungsarme 26a, 26b herstellt werden kann. Daher ist an dem Greifer 29 zusätzlich die Spule 40' vorgesehen. Bei der in Fig. 6b gezeigten Superpositionsstellung befindet sich die Spule 40' über einem Magneten 42', der an dem Führungsarm 26b angeordnet ist. Durch eine geeignete Bestromung der Spule 40' kann auch diese Superpositionsstellung in kontrollierter Weise aufgelöst werden.

Zusätzlich zu den gezeigten Spulen 40, 40' können an den unteren Ecken des Greifers 29 ebenfalls Spulen angeordnet sein. Werden jeweils schräg gegenüberliegende Spulen mit unterschiedlicher Polarität bestromt, so wird einerseits eine Kopplung und andererseits eine Abstoßung zwischen den Spulen und den jeweiligen Magneten erzeugt, wodurch eine noch bessere Kontrolle der Auflösung der Superpositionsstellung ermöglicht wird und/oder eine geringer Bestromung der Spulen erforderlich ist, um den gewünschten Effekt zu erzielen.

Grundsätzlich ist es auch möglich, die Spulen 40, 40' den Führungsarmen 26a, 26b zuzuordnen und die entsprechenden Magneten 42, 42' an dem Greifer 29 anzuordnen. Bevorzugt ist allerdings die Anordnung der Spulen 40, 40' an dem Greifer 29, da sich dieser - sofern ein Kompensationsmechanismus 30 oder eine wirkungsgleiche Vorrichtungen vorgesehen sind - während der Bewegungen der Läufer 22a, 22b nicht dreht, was die Stromzuführung für die Spulen 40, 40' erleichtert.

Die vorstehend beschriebene Funktionalität der Überlagerungseinheit 38 kann auch dadurch erreicht werden, dass man den in Fig. 4 gezeigten Kompensationsmechanismus 30 leicht abwandelt. Zu diesem Zweck ist das Zahnrad 36 nicht drehfest an dem Läufer 22a befestigt, sondern kann beispielsweise durch einen Elektromotor in kontrollierter Weise aktiv verdreht werden. Dadurch kann auf den Greifer 29 eine Kraft ausgeübt werden, die gleichwirkend mit der vorstehend beschriebenen Kopplung des Greifers 29 mit den Führungsarmen 26a, 26b ist. Bevorzugt ist es in diesem Fall, wenn der abgewandelte Kompensationsmechanismus 30 symmetrisch aufgebaut ist und beide den Läufern 22a, 22b zugeordnete Zahnräder 36 aktiv verdrehbar sind. Durch eine gegensinnige Rotation der Zahnräder 36 kann eine effiziente Auflösung der Superpositionsstellungen erreicht werden.

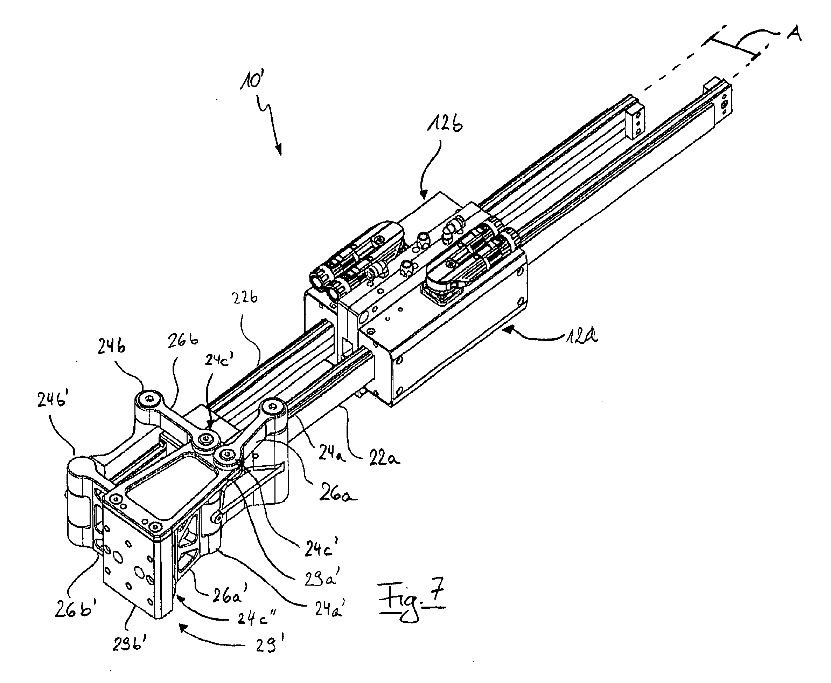

Fig. 7 zeigt eine Ausführungsform 10' der erfindungsgemäßen Manipulationsvorrichtung. Wie die Manipulationsvorrichtung 10 weist sie zwei Linearmotoren 12a, 12b auf, die symmetrisch angeordnet sind. Details zu einer vertikalen Verfahrbarkeit der Linearmotoren 12a, 12b sind in Fig. 7 nicht gezeigt. Grundsätzlich ist es jedoch möglich, eine solche Verfahrbarkeit und/oder den eine drehbare Basis, mit der die Motoren 12a, 12b direkt oder indirekt in Verbindung stehen, vorzusehen. Die Manipulationsvorrichtung 10' kann - wie die Manipulationsvorrichtung 10 - beliebig im Raum orientiert sein.

Die Läufer 22a, 22b der Motoren 12a, 12b der Manipulationsvorrichtung 10' sind im Grundsatz so aufgebaut wie die der Manipulationsvorrichtung 10.

Der entscheidende Unterschied zwischen den Manipulationsvorrichtungen 10 und 10' besteht in der Ausgestaltung der Kopplung zwischen den Läufern 22a, 22b, mit deren Hilfe eine Bewegung eines Werkstücks oder eines Werkzeugs in einer durch die Läufer 22a, 22b aufgespannten Ebene erzeugt werden kann. Neben den Führungsarmen 26a, 26b sind bei der Manipulationsvorrichtung 10' zusätzliche Führungsarme 26a', 26b' vorgesehen, durch die eine erhöhte Stabilität und insbesondere eine andere Bewegungsdynamik erzielt wird. Außerdem sind die Führungsarme 26a, 26b nicht direkt durch ein gemeinsames Drehgelenk 24c miteinander gekoppelt, wie es bei der Manipulationsvorrichtung 10 der Fall ist, sondern die Führungsarme 26a, 26b der Manipulationsvorrichtung 10' sind über separate Drehgelenke 24c' mit einer Basisplatte 29a' einer Befestigungseinrichtung 29' gekoppelt. Die Befestigungseinrichtung 29' umfasst ferner eine Arbeitsplatte 29b', die fest mit der Basisplatte 29a' verbunden ist.

Die Führungsarme 26a', 26b' sind einerseits über Drehgelenke 24a' bzw. 24b' mit den Läufern 22a bzw. 22b gekoppelt. Auf Seiten der Befestigungseinrichtung 29' erfolgt eine Anbindung der Führungsarme 26a' und 26b' über separate Drehgelenke 24c", die anhand der nachfolgenden Figuren noch genauer beschrieben werden.

Die Arbeitsplatte 29b' definiert eine Frontalebene, die senkrecht zur Längserstreckung der Läufer 22a, 22b ausgerichtet ist. An ihrer Vorderseite, das heißt an der den Motoren 12a, 12b abgewandten Seite der Arbeitsplatte 29b', kann beispielsweise ein Werkstück, ein Greifer und/oder ein Werkzeug zur Bearbeitung von Werkstücken befestigt werden. Die Basisplatte 29a' stellt sicher, dass die zwei Drehgelenke 24c' und die zwei Drehgelenke 24c" in einem festen räumlichen Verhältnis zueinander stehen. Da die Führungsarme 26a, 26b, 26a', 26b' alle gleich lang sind, spannen sie bei der vorgegebenen Drehgelenkanordnung ein Parallelogramm auf, das dafür sorgt, dass die Frontalebene der Arbeitsplatte 29b' durch eine Bewegung der Läufer 22a, 22b nicht verdreht wird. Mit anderen Worten wird die Frontalebene zwar innerhalb einer durch die Läufer 22a, 22b aufgespannten Ebene verschoben, jedoch nicht verschwenkt. Das Vorsehen der zusätzlichen Führungsarme 26a', 26b' führt nicht nur zu einer für viele Anwendungen vorteilhaften Dynamik der Manipulationsvorrichtung 10', sondern erhöht auch ihre Stabilität.

In dem in Fig. 7 gezeigten Zustand befinden sich die Läufer 22a, 22b der Linearmotoren 12a, 12b in unterschiedlichen Positionen. Der Läufer 22b ist im Vergleich zu dem Läufer 22a weiter "ausgefahren", sodass die Befestigungseinrichtung 29' von den Motoren 12a, 12b aus gesehen nach links versetzt wurde. Mit anderen Worten führt eine unterschiedliche Bewegung der Läufer 22a, 22b zu einem seitlichen Versatz der Befestigungseinrichtung 29'. Es versteht sich, dass der Betrag des Versatzes unter anderem eine Funktion eines Abstands A der Läufer 22a, 22b und der Länge der Führungsarme 26a, 26b, 26a', 26b' ist. Durch eine Vergrößerung des Abstands A zwischen den Läufern 22a, 22b und/oder durch eine Verlängerung der Führungsarme 26a, 26b, 26a', 26b' kann der Bewegungsspielraum der Manipulationsvorrichtung 10' vergrößert werden.

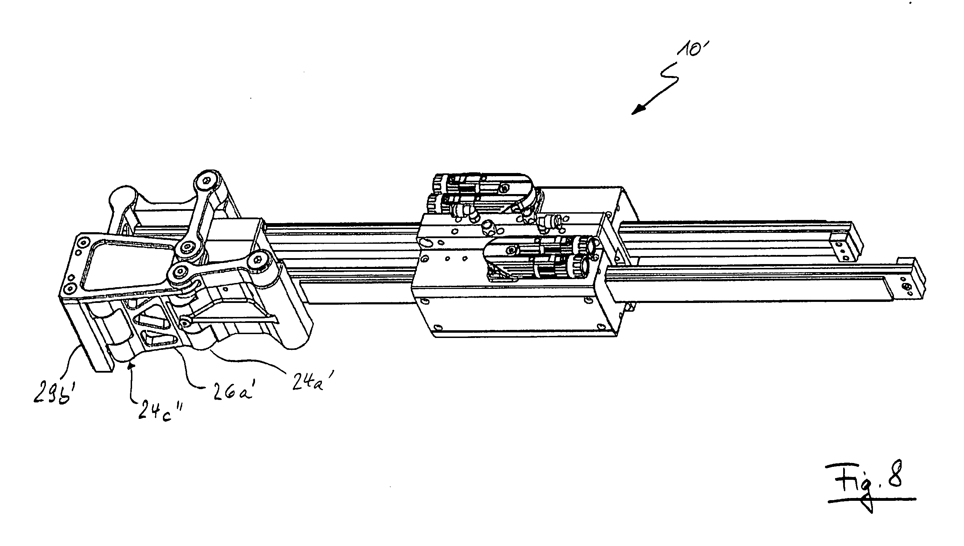

Fig. 8 zeigt eine weitere Ansicht der Manipulationsvorrichtung 10' aus einem anderen Blickwinkel. Dadurch ist das Drehgelenke 24c" besser zu erkennen, durch das der Führungsarm 26a' mit der Arbeitsplatte 29b' gekoppelt ist.

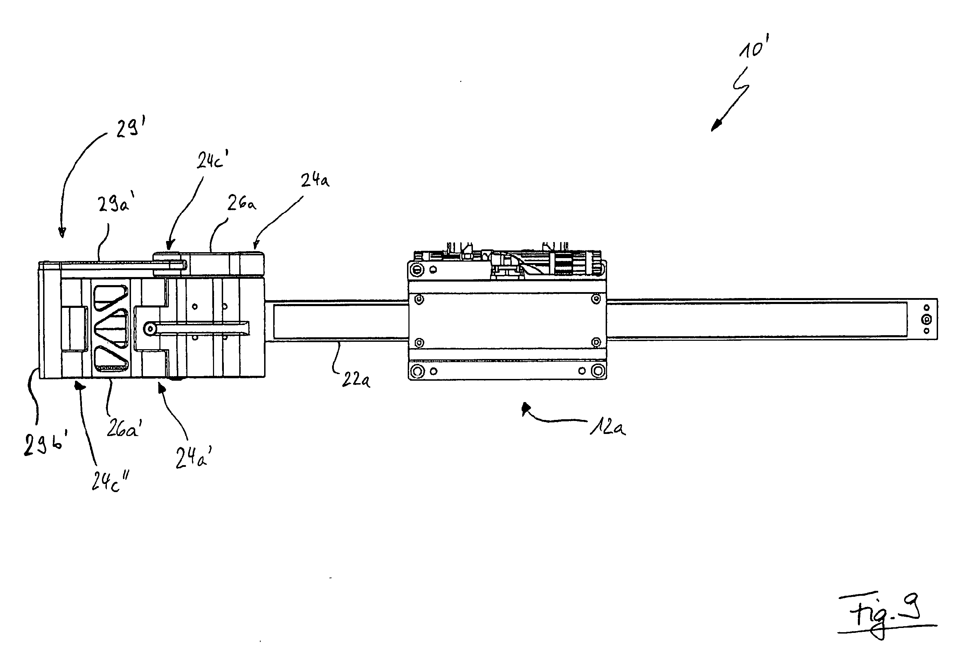

Fig. 9 zeigt eine Seitenansicht der Manipulationsvorrichtung 10', wodurch deutlich erkennbar ist, dass eine vertikale Erstreckung der Führungsarme 26a, 26b wesentlich geringer ist als die der Führungsarme 26a', 26b' (Führungsarm 26b' ist in Fig. 9 nicht zu sehen, gleicht aber im Wesentlichen dem Führungsarm 26a'). Die Führungsarme 26a', 26b' sind so ausgestaltet, dass sie in der Lage sind, die Hauptlast eines mit der Arbeitsplatte 29b' verbundenen Gegenstands oder Werkzeugs zu tragen. Die vergleichsweise dünne Basisplatte 29a' trägt wie die Führungsarme 26a, 26b kaum Lasten. Diese Komponenten dienen hauptsächlich zur Festlegung der Dynamik der Befestigungseinrichtung 29'.

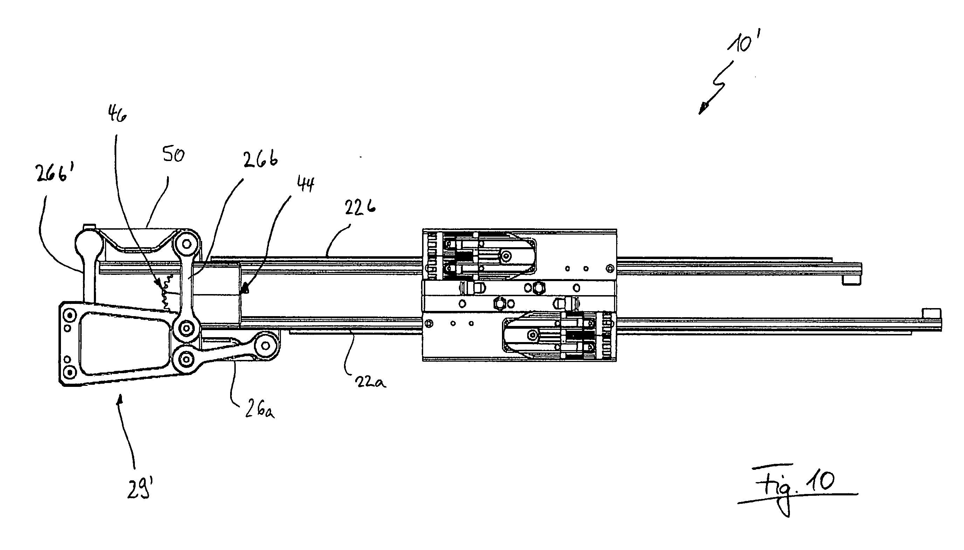

Fig. 10 zeigt eine Draufsicht auf die Manipulationsvorrichtung 10'. Ihr ist zu entnehmen, dass die Führungsarme 26b, 26b' an einem Grundkörper 50 verschwenkbar befestigt sind, der wiederum in fester Verbindung mit dem Läufer 22b steht. Analoges gilt für die Führungsarme 26a, 26a'. Grundsätzlich ist es auch möglich, an den Läufern 22a, 22b Einrichtungen vorzusehen, durch die die Führungsarme 26a, 26b, 26a', 26b' direkt verschwenkbar an den Läufern 22a, 22b befestigt werden können.

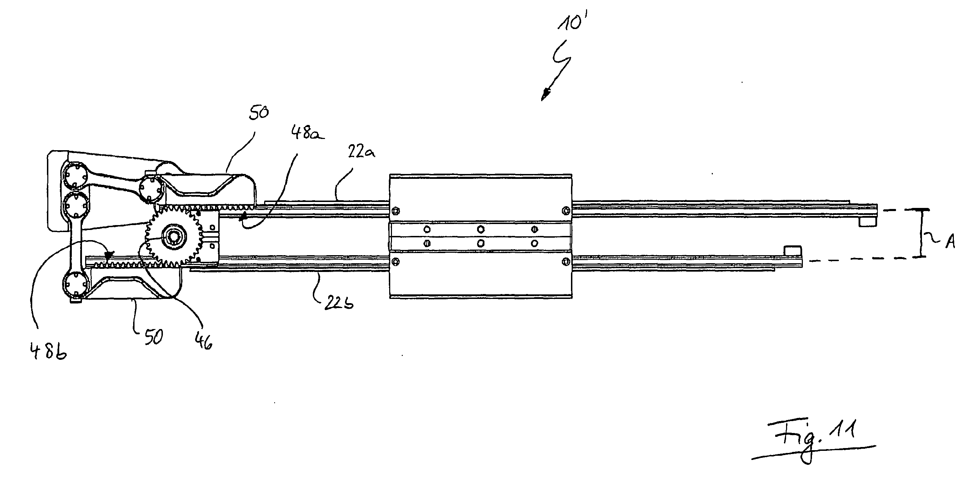

Fig. 10 zeigt ferner, dass die Läufer 22a, 22b nicht nur über die Führungsarme 26a, 26b, 26a', 26b' und die Befestigungseinrichtung 29' miteinander in Verbindung stehen. Neben dieser indirekten Kopplung ist eine direkte Kopplung der Läufer 22a, 22b vorgesehen, um die Stabilität der Manipulationseinrichtung 10' zu erhöhen und um insbesondere zu verhindern, dass die Läufer 22a, 22b bei Betrieb der Manipulationsvorrichtung 10' auseinandergedrückt werden. Zu diesem Zweck ist ein Kopplungsschlitten 44 vorgesehen, der sowohl an dem Läufer 22a als auch an dem Läufer 22b verfahrbar angeordnet ist. Mit anderen Worten kann der Kopplungsschlitten 44 zwar entlang der Läufer 22a, 22b bewegt werden, allerdings koppelt er die Läufer 22a, 22b in einer Richtung quer zu deren Bewegungsrichtung, um sicherzustellen, dass diese nicht zusammen- oder auseinandergedrückt werden. Diese Kopplung ist insbesondere im vorderen Bereich der Läufer 22a, 22b von Bedeutung, da in diesem Bereich bei Betrieb der Manipulationsvorrichtung 10' Kräfte auftreten, die letztlich durch die indirekte Kopplung und die Belastung durch das Werkstück oder Werkzeug erzeugt werden. Insbesondere in einem "ausgefahrenen" Zustand der Läufer 22a, 22b können diese Kräfte nicht unerhebliche Biegemomente erzeugen, die auf die Läufer 22a, 22b wirken. Um zu verhindern, dass der Kopplungsschlitten 44 während des Betriebs den vorstehend beschriebenen Bereich verlässt, ist ein Mechanismus mit einem an dem Schlitten 44 angeordneten Zahnrad 46 vorgesehen, dessen Funktion anhand von Fig. 11 näher erläutert wird.

Fig. 11 zeigt eine Ansicht der Manipulationsvorrichtung 10' von unten. Das vorstehend erwähnte Zahnrad 46 kämmt mit Verzahnungen 48a, 48b, die an den Grundkörpern 50 angeordnet sind. Durch das Zusammenspiel der Bewegungen der Läufer 22a, 22b und die Kopplung mittels des Zahnrads 46 und der Verzahnungen 48a, 48b wird der Kopplungsschlitten 44 stets in einem Bereich gehalten, der in etwa durch die Drehgelenke 24a, 24a' bzw. 24b, 24b' begrenzt wird. D.h. der Kopplungsschlitten 44 stabilisiert die Läufer 22a, 22b stets dort, wo die größten Biegeund Quermomente zu erwarten sind, indem er den Abstand A zwischen den Läufern 22a, 22b im Wesentlichen konstant hält. Es versteht sich, dass das Funktionsprinzip des Kopplungsschlittens 44 grundsätzlich auch auf die Manipulationsvorrichtung 10 übertragbar ist.

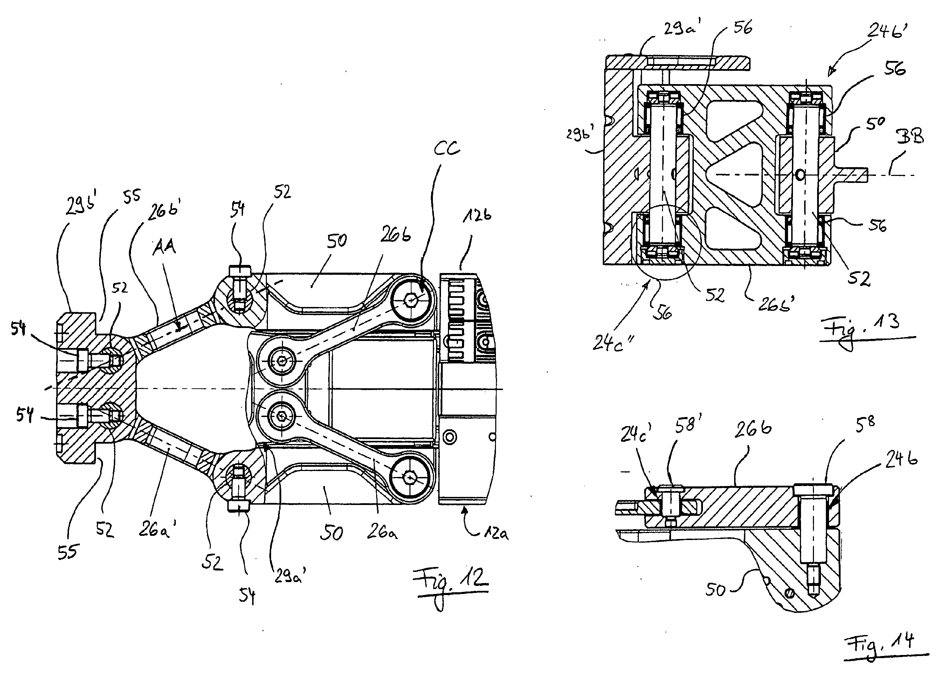

Anhand der Fig. 12 bis 14 wird nachfolgend nochmals die Ausgestaltung der indirekten Kopplung der Läufer 22a, 22b näher erläutert, die die Dynamik der von der Manipulationsvorrichtung 10' erzeugbaren Bewegung bestimmt.

Fig. 12 zeigt eine Draufsicht auf einen Teil der Manipulationsvorrichtung 10'. Die Läufer 22a, 22b sind in einem "eingefahrenen" Zustand, sodass die Grundkörper 50 fast an den entsprechenden Motoren 12a, 12b anliegen. Ein Teil der Basisplatte 29a' wurde entfernt, um einen horizontalen Schnitt durch die Arbeitsplatte 29b' und die Führungsarme 26a', 26b' zeigen zu können. Zu erkennen ist, dass Schwenkbolzen 52, durch die die Führungsarme 26a', 26b' verschwenkbar an dem jeweiligen Grundkörper 50 bzw. an der Arbeitsplatte 29b' gelagert sind, durch Bolzen 54 drehfest an dem entsprechenden Grundkörper 50 bzw. der Arbeitsplatte 29b' gesichert sind.

Fig. 12 zeigt ferner, dass die Arbeitsplatte 29b' durch die Ausgestaltung ihrer den Motoren 12a, 12b zugewandten Seite eine maximale Verschwenkung der Arme 26a', 26b' begrenzt. Durch Anschläge 55 wird festgelegt, dass die Arme 26a', 26b' maximal etwas über 90 °relativ zu der Längserstreckung der Läufer 22a, 22b verschwenkt werden können. Eine solche Maximalverschwenkung ist in den Figs. 7 bis 11 gezeigt.

Fig. 13 zeigt einen Schnitt durch den Führungsarm 26b' und die Arbeitsplatte 29a' entlang einer Schnittebene AA, deren Lage in Fig. 12 gezeigt ist. Es ist zu sehen, dass die Schwenkbolzen 52 durch Lager 56 (in einem Fall durch einen Markierungskreis hervorgehoben) drehbar an dem Führungsarm 26b' gelagert sind. Grundsätzlich ist auch eine inverse Ausgestaltung denkbar, bei der die Schwenkbolzen 52 fest an dem Führungsarm 26b' fixiert sind, während die Lager 56 an der Arbeitsplatte 29a' bzw. dem Grundkörper 50 vorgesehen sind.

In Fig. 13 ist auch die Lage einer Schnittebene BB angegeben, die der Schnittebene des linken Teils der Fig. 12 entspricht.

Fig. 14 zeigt einen Schnitt durch den Führungsarm 26b entlang der Schnittebene CC, deren Lage ebenfalls der Fig. 12 zu entnehmen ist. Da der Führungsarm 26b, wie vorstehend bereits beschrieben, kaum belastet wird, sondern hauptsächlich zur Führung der Befestigungseinrichtung 29' dient, ist er wesentlich leichter ausgeführt als der Führungsarm 26b'. Die Lagerung des Führungsarms 26b ist ebenfalls deutlich einfacher ausgeführt als die Lagerung des Führungsarms 26b' und erfolgt mittels Schwenkzapfen 58, 58', die letztlich die Drehgelenke 24b bzw. 24c' bilden.

Es versteht sich, dass die Ausführungen zu den Führungsarmen 26b, 26b' in analoger Form für die Führungsarme 26a, 26a' gelten.

Einer der Vorteile der Manipulationsvorrichtungen 10, 10' besteht darin, dass beide Läufer 22a, 22b eine Belastung durch das im Bereich der Führungsarme 26a, 26b angeordnete Werkstück oder Werkzeug aufnehmen. Bei vergleichbar kompakter Bauweise und Dimensionierung der Motoren 12a, 12b können daher größere Lasten bewegt werden können als bei herkömmlichen Industrierobotern. Außerdem ist die Stabilität der Manipulationsvorrichtungen 10, 10' insgesamt verbessert. Aufgrund der hohen Dynamik von Linearmotoren lassen sich die Manipulationsvorrichtungen 10, 10' zudem effizient betreiben. Ein weiterer Vorteil besteht darin, dass die Linearmotoren 12a, 12b im Wesentlichen baugleich sein können, so dass ein Wartungs- und Justieraufwand minimiert ist.

### Bezugszeichenliste

- 10, 10': Manipulationsvorrichtung
- 12a, 12b, 16: Linearmotor
- 14: Basis
- 17: Schlitten
- 18, 18': Spule
- 22a, 22b: Läufer
- 24a, 24b, 24c, 24a', 24b', 24c', 24c": Drehgelenk
- 26a, 26b, 26a', 26b': Führungsarm
- 28, 28': Anschlag
- 29: Greifer
- 29': Befestigungseinrichtung
- 29a': Basisplatte
- 29b': Arbeitsplatte
- 30: Kompensationsmechanismus
- 32, 36: Zahnrad
- 34 , 34': Band
- 38: Überlagerungseinheit
- 40, 40': Spule
- 42, 42': Magnet
- 44: Kopplungsschlitten
- 46: Zahnrad
- 48a, 48b: Verzahnung
- 50: Grundkörper
- 52: Schwenkbolzen
- 54: Bolzen
- 55: Anschlag
- 56: Lager
- 58, 58': Schwenkzapfen

- A: Abstand
- B1, B2: lineare Bewegungsrichtung
- L: Linie
- K: Kreisbahn

## Patentansprüche

1. Manipulationsvorrichtung zur Handhabung und/oder Bearbeitung eines Werkstücks, umfassend eine erste Bewegungseinheit (12a) zur Erzeugung einer linearen Bewegung (B1) eines ersten Bauteils (22a) und eine zweite Bewegungseinheit (12b) zur Erzeugung einer linearen Bewegung (B2) eines zweiten Bauteils (22b),
wobei die Bewegungseinheiten insbesondere Linearmotoren (12a, 12b) sind,
wobei die Bewegungseinheiten (12a, 12b) derart relativ zueinander angeordnet sind, dass die von den Bewegungseinheiten (12a, 12b) erzeugbaren Bewegungen (B1, B2) des ersten Bauteils (22a) und des zweiten Bauteils (22b) parallel zueinander ausgerichtet sind,
wobei das erste Bauteil (22a) über eine erste gelenkige Verbindung (24a, 26a) und das zweite Bauteil (22b) über eine zweite gelenkige Verbindung (24b, 26b) mit einem Befestigungselement (29, 29') verbunden sind, das zur Aufnahme des Werkstücks und/oder eines. Werkzeugs geeignet ist,
wobei die erste gelenkige Verbindung einen ersten Führungsarm (26a) umfasst, der mittels eines Drehgelenks (24a) mit dem ersten Bauteil (22a) gekoppelt ist,
wobei die zweite gelenkige Verbindung einen zweiten Führungsarm (26b) umfasst, der mittels eines Drehgelenks (24b) mit dem zweiten Bauteil (22b) gekoppelt ist,
wobei der erste Führungsarm (26a) und der zweite Führungsarm (26b) durch zumindest ein Drehgelenk (24c, 24c') relativ zueinander verschwenkbar direkt oder indirekt miteinander gekoppelt sind
wobei der erste Führungsarm (26a) und der zweite Führungsarm (26b) durch separate Drehgelenke (24c') mit dem Befestigungselement (29') gekoppelt sind, und
wobei die erste gelenkige Verbindung einen dritten Führungsarm (26a') umfasst, der mittels eines Drehgelenks (24a') mit dem ersten Bauteil (22a) gekoppelt ist, und dass die zweite gelenkige Verbindung einen vierten Führungsarm (26b') umfasst, der mittels eines Drehgelenks (24b') mit dem zweiten Bauteil (22b) gekoppelt ist,
**dadurch gekennzeichnet**, dans das Befestigungselement (29') eine Basisplatte (29a') und eine Arbeitsplatte (29b') umfasst, wobei der erste Führungsarm (26a) und der zweite Führungsarm (26b) durch separate Drehgelenke (24c') mit der Basisplatte (29a') gekoppelt sind und wobei der dritte Führungsarm (26a') und der vierte Führungsarm (26b') durch separate Drehgelenke (24c") mit der Arbeitsplatte (29b') gekoppelt sind.

2. Manipulationsvorrichtung nach Anspruch 1,
**dadurch gekennzeichnet, dass**
die Basisplatte (29a') und die Arbeitsplatte fest miteinander verbunden sind.

3. Manipulationsvorrichtung nach zumindest einem der vorstehenden Ansprüche,
**dadurch gekennzeichnet, dass**
der erste Führungsarm (26a) und der dritte Führungsarm (26a') gleich lang sind und dass der zweite Führungsarm (26b) und der vierte Führungsarm (26b') gleich lang sind, wobei insbesondere alle Führungsarme (26a, 26a', 26b, 26b') gleich lang sind.

4. Manipulationsvorrichtung nach zumindest einem der vorstehenden Ansprüche,
**dadurch gekennzeichnet, dass**
ein Kopplungselement (44) vorgesehen ist, dass zusätzlich zu einer Kopplung über die gelenkigen Verbindungen und das Befestigungselement (29') eine weitere Kopplung zwischen dem ersten Bauteil (22a) und dem zweiten Bauteil (22b) herstellt.

5. Manipulationsvorrichtung nach Anspruch 4,
**dadurch gekennzeichnet, dass**
das Kopplungselement (44) an dem ersten Bauteil (22a) und an dem zweiten Bauteil (22b) verfahrbar angeordnet ist, wobei das Kopplungselement (44) insbesondere parallel zu den Bewegungsrichtungen (B1, B2) der Bauteile (22a bzw. 22b) verfahrbar ist, und/oder wobei das Kopplungselement (44) insbesondere ein Zahnrad (46) umfasst, das mit einer an dem ersten Bauteil (22a) angeordneten Verzahnung (48a) und mit einer an dem zweiten Bauteil (22b) angeordneten Verzahnung (48b) kämmt.

6. Manipulationsvorrichtung nach einem der vorstehenden Ansprüche,
**dadurch gekennzeichnet, dass**
die erste und die zweite Bewegungseinheit (12a, 12b) in einer Ebene angeordnet sind, die in Gebrauchslage der Manipulationsvorrichtung im Wesentlichen horizontal angeordnet ist, und/oder dass die Bewegungseinheiten (12a, 12b) an einer gemeinsamen Basis (14) oder an separaten Basiseinheiten verfahrbar angeordnet sind, wobei sich eine Verfahrrichtung der Bewegungseinheiten (12a, 12b) - bezogen auf eine Gebrauchslage der Manipulationsvorrichtung - insbesondere senkrecht zu den von den Bewegungseinheiten (12a, 12b) erzeugbaren linearen Bewegungen (B1, B2) des ersten und des zweiten Bauteils (22a, 22b) erstreckt.

7. Manipulationsvorrichtung nach zumindest einem der vorstehenden Ansprüche,
**dadurch gekennzeichnet, dass**
die Summe einer Längserstreckung der ersten und einer Längserstreckung der zweiten gelenkigen Verbindung (24a, 26a, bzw. 24b, 26b) größer ist als ein Abstand (A) zwischen den Bewegungsrichtungen (B1, B2) der Bewegungseinheiten (12a, 12b).

## Claims

1. A manipulation apparatus for handling and/or processing a workpiece comprising a first movement unit (12a) for generating a linear movement (B1) of a first component (22a) and a second movement unit (12b) for generating a linear movement (B2) of a second component (22b),
wherein the movement units are in partiuclar linear motors (12a, 12b);
wherein the movement units (12a, 12b) are arranged relative to one another such that the movements (B 1, B2) of the first component (22a) and of the second component (22b) which can be generated by the movement units (12a, 12b) are aligned in parallel with one another;
wherein the first component (22a) is connected via a first pivotal connection (24a, 26a) and the second component (22b) is connected via a second pivotal connection (24b, 26b) to a fastening element (29, 29') which is suitable for taking up the workpiece and/or a tool;
wherein the first pivotal connection includes a first guide arm (26a) which is coupled to the first component (22a) by means of a pivot joint (24a);
wherein the second pivotal connection includes a second guide arm (26b) which is coupled to the second component (22b) by means of a pivot joint (24b);
wherein the first guide arm (26a) and the second guide arm (26b) are coupled to one another directly or indirectly in a manner pivotable relative to one another by at least one pivot joint (24c, 24c');
wherein the first guide arm (26a) and the second guide arm (26b) are coupled to the fastening element (29') by separate pivot joints (24c'); and
wherein the first pivotal connection includes a third guide arm (26a') which is coupled to the first component (22a) by means of a pivot joint (24a'); and wherein the second pivotal connection includes a fourth guide arm (26b') which is coupled to the second component (22b) by means of a pivot joint (24b'),
**characterized in that**
the fastening element (29') includes a base plate (29a') and a work plate (29b'), with the first guide arm (26a) and the second guide arm (26b) being coupled to the base plate (29a') by separate pivot joints (24c'), and with the third guide arm (26a') and the fourth guide arm (26b') being coupled to the work plate (29b') by separate pivot joints (24c").

2. A manipulation apparatus in accordance with claim 1,
**characterized in that**
the base plate (29a') and the work plate are fixedly connected to one another.

3. A manipulation apparatus in accordance with at least one of the preceding claims,
**characterized in that**
the first guide arm (26a) and the third guide arm (26a') are of equal length; and **in that** the second guide arm (26b) and the fourth guide arm (26b') are of equal length, with in particular all guide arms (26a, 26a', 26b, 26b') being of equal length.

4. A manipulation apparatus in accordance with at least one of the preceding claims,
**characterized in that**
a coupling element (44) is provided which establishes a further coupling between the first component (22a) and the second component (22b) in addition to a coupling via the pivotal connections and the fastening element (29').

5. A manipulation apparatus in accordance with claim 4,
**characterized in that**
the coupling element (44) is arranged movable at the first component (22a) and at the second component (22b), with the coupling element (44) being travelable in particular in parallel with the directions of movement (B1, B2) of the components (22a and 22b respectively); and/or with the coupling element (44) in particular including a toothed wheel (46) which meshes with a toothed arrangement (48a) arranged at the first component (22a) and with a toothed arrangement (48b) arranged at the second component (22b).

6. A manipulation apparatus in accordance with any one of the preceding claims,
**characterized in that**
the first and the second movement units (12a, 12b) are arranged in a plane which is arranged substantially horizontal in the position of use of the manipulation apparatus; and/or **in that** the movement units (12a, 12b) are arranged movable at a common base (14) or at separate base units, with a direction of travel of the movement units (12a, 12b) extending - with respect to a position of use of the manipulation apparatus - in particular perpendicular to the linear movements (B1, B2) of the first and second components (22a, 22b) which can be generated by the movement units (12a, 12b).

7. A manipulation apparatus in accordance with at least one of the preceding claims,
**characterized in that**
the sum of a longitudinal extent of the first pivotal connection and a longitudinal extent of the second pivotal connection (24a, 26a and 24b, 26b respectively) is larger than a spacing (A) between the directions of movement (B1, B2) of the movement units (12a, 12b).

## Revendications

1. Dispositif de manipulation pour la manutention et/ou l'usinage d'une pièce à oeuvrer, comprenant une première unité de déplacement (12a) pour engendrer un déplacement linéaire (B1) d'un premier composant (22a) et une seconde unité de déplacement (12b) pour engendrer un déplacement linéaire (B2) d'un second composant (22b),
dans lequel les unités de déplacement sont en particulier des moteurs linéaires (12a, 12b),
dans lequel les unités de déplacement (12a, 12b) sont agencées l'une par rapport à l'autre de telle façon que les déplacements (B1, B2), susceptibles d'être engendrés par les unités de déplacement (12a, 12b), du premier composant (22a) et du second composant (22b) sont orientés parallèlement l'un à l'autre,
dans lequel le premier composant (22a) est relié via une première liaison articulée (24a, 26a) et le second composant (22b) est relié via une seconde liaison articulée (24b, 26b) avec un premier élément de fixation (29, 29'), qui convient pour recevoir la pièce à oeuvrer et/ou un outil,
dans lequel la première liaison articulée comprend un premier bras de guidage (26a), qui est accouplé avec le premier composant (22a) au moyen d'une articulation rotative (24a),
dans lequel la seconde liaison articulée comprend un second bras de guidage (26b), qui est accouplé avec le second composant (22b) au moyen d'une articulation rotative (24b),
dans lequel le premier bras de guidage (26a) et le second bras de guidage (26b) sont accouplés d'un avec l'autre directement ou indirectement avec faculté de pivotement l'un par rapport à l'autre par au moins une articulation rotative (24c, 24c'),
dans lequel le premier bras de guidage (26a) et le second bras de guidage (26b) sont accouplés avec l'élément de fixation (29') via des articulations rotatives séparées (24c'),
et
dans lequel la première liaison articulée comprend un troisième bras de guidage (26a') qui est accouplé avec le premier composant (22a) au moyen d'une articulation rotative (24a'), et en ce que la seconde liaison articulée comprend un quatrième bras de guidage (26b'), qui est accouplé avec le second composant (22b) au moyen d'une articulation rotative (24b'),
**caractérisé en ce que**
l'élément de fixation (29') comprend une plaque de base (29a') et une plaque de travail (29b'), dans lequel le premier bras de guidage (26a) et le second bras de guidage (26b) sont accouplés avec la plaque de base (29a') par des articulations rotatives séparées (24c'), et dans lequel le troisième bras de guidage (26a') et le quatrième bras de guidage (26b') sont accouplés avec la plaque de travail (29b') par des articulations rotatives séparées (24c').

2. Dispositif de manipulation selon la revendication 1,
**caractérisé en ce que** la plaque de base (20a') et la plaque de travail sont reliées fermement l'une avec l'autre.

3. Dispositif de manipulation selon l'une au moins des revendications précédentes,
**caractérisé en ce que** le premier bras de guidage (26a) et le troisième bras de guidage (26a') ont la même longueur, et **en ce que** le second bras de guidage (26b) et le quatrième bras de guidage (26b') ont la même longueur, et en particulier tous les bras de guidage (26a, 26a', 26b, 26b') ont la même longueur.

4. Dispositif de manipulation selon l'une au moins des revendications précédentes,
**caractérisé en ce qu'**il est prévu un élément d'accouplement (44), qui établit en supplément d'un accouplement via les liaisons articulées et l'élément de fixation (29') un autre accouplement entre le premier composant (22a) et le second composant (22b).

5. Dispositif de manipulation selon la revendication 4,
**caractérisé en ce que** l'élément d'accouplement (44) est agencé déplaçable sur le premier composant (22a) et sur le second composant (22b), et l'élément d'accouplement (44) est déplaçable en particulier parallèlement aux directions de déplacement (B1, B2) des composants (22a ou 22b), et/ou dans lequel l'élément d'accouplement (44) comprend en particulier une roue dentée (46), qui engrène avec une denture (48a) ménagée sur le premier composant (22a) et avec une denture (48b) ménagée sur le second composant (22b).

6. Dispositif de manipulation selon l'une des revendications précédentes,
**caractérisé en ce que** la première et la seconde unité de déplacement (12a, 12b) sont agencées dans un plan qui, dans la position d'utilisation du dispositif de manipulation, est agencé essentiellement horizontal, et/ou **en ce que** les unités de déplacement (12a, 12b) sont agencées mobiles sur une base commune (14) ou sur des unités de base séparées, dans lequel une direction de mouvement des unités de déplacement (12a, 12b) s'étend, par référence à une position d'utilisation du dispositif de manipulation, en particulier perpendiculairement aux déplacements linéaires (B1, B2), susceptibles d'être engendrés par les unités de déplacement (12a, 12b), du premier et du second composant (22a, 22b).

7. Dispositif de manipulation selon l'une au moins des revendications précédentes,
**caractérisé en ce que** la somme d'une extension en longueur de la première liaison articulée (24a, 26a) et d'une extension en longueur de la seconde liaison articulée (24b, 26b) est plus grande une distance (A) entre les directions de déplacement (B1, B2) des unités de déplacement (12a, 12b).
